# EUROPEAN PATENT APPLICATION

(11) **EP 2 432 006 A1**
(43) Date of publication of application: **21.03.2012**
(21) Application number: 10789262.2
(22) Date of filing: 02.02.2010
(51) Int. Cl.: H01L 21/60

(54) **SEMICONDUCTOR CHIP AND STRUCTURE FOR MOUNTING SAME**

(30) Priority: 16.06.2009 JP 2009142950
(71) Applicant: Sharp Kabushiki Kaisha, Osaka-shi, Osaka 545-8522 (JP)
(72) Inventor: SHIOTA, Motoji, Osaka 545-8522 (JP); NAKAHAMA, Hiroki, Osaka 545-8522 (JP); MATSUI, Takashi, Osaka 545-8522 (JP); HORIGUCHI, Takeshi, Osaka 545-8522 (JP)
(74) Representative: Müller-Boré & Partner Patentanwälte
(86) International application number: PCT/JP2010/051415
(87) International publication number: WO 2010/146884

(57) **Abstract**

Provided is a semiconductor chip having a narrowed pitch between terminals, the chip being capable of suppressing occurrence of poor connection between the chip and a substrate on which the chip is mounted. In an LSI chip (10) including an input bump group (110), which is composed of a plurality of input bumps (11) aligned in a line along one long side of its bottom surface, and an output bump group (120), which is composed of a plurality of output bumps (12) arranged in a staggered manner along the other long side of the bottom surface, a dummy bump group (130) is provided in an area between an area where the input bump group (110) is provided and an area where the output bump group (120) is provided, the dummy bump group (130) including a plurality of rectangular dummy bumps (bumps without a function of electrical connection) (13) which have long side extending along a direction perpendicular to the long sides of the bottom surface.

## Description

### TECHNICAL FIELD

The present invention relates to semiconductor chips and mounting structures of such semiconductor chips, and in particular, to a structure of a semiconductor chip that is mounted on a substrate using an adhesive agent having a conductive property and a mounting structure as to how the semiconductor chip is mounted on a substrate.

### BACKGROUND ART

In recent years, downsizing and thinning of electronic devices have been increasingly demanded. Because of this, there have been proposed various methods of mounting an IC (Integrated Circuit) chip or an LSI (Large Scale Integration) chip (hereinafter collectively and simply referred to as a "chirp") on a circuit board. For example, "flip chip mounting" is known as a mounting method that realizes mounting of a chip on a circuit board with a very small area. The flip chip mounting is a mounting method of forming a bump electrode referred to as a "bump" on a surface of an unpackaged chip referred to as a "bare chip", and of directly electrically connecting the chip to a circuit board with a circuit side of the chip facing down.

In the flip chip mounting, an anisotropic conductive material is commonly used for bonding the circuit board and the chip. The anisotropic conductive material is a connecting material having a conductive property in a through-thickness direction at a pressure-bonded portion and an insulation property in a planar direction at a pressure-bonded portion. The anisotropic conductive material mainly composed of conductive particles and a resin serving as an adhesive agent (hereinafter referred to as an "adhesive resin") (conductive particles are dispersed in an adhesive resin). When bonding, heat and a pressure are applied to a bonding portion, thereby spreading the adhesive resin. At this time, opposite electrodes that face each other become electrically continuous by the conductive particles being sandwiched (captured) between the opposite electrodes. Note that, an amount of the conductive particles added to the adhesive resin is designed according to an area of the electrodes for connection and a space between the electrodes.

Typically, an adhesive agent in paste form referred to as an ACP (Anisotropic Conductive Paste) and an adhesive agent in film form referred to as an ACF (Anisotropic Conductive Film) are known as the anisotropic conductive materials. The ACP and the ACF are an adhesive agent in which conductive particles such as nickel particles or gold-plated plastic particles are dispersed in an adhesive agent composed of a thermosetting resin such as an epoxy resin. Comparing the ACP with the ACF, the conductive particles are more fluid in the ACP than in the ACF. Accordingly, the ACP has a disadvantage that the conductive particles may not be easily captured between the electrodes when bonding. By contrast, the ACF has an advantage that the conductive particles can be easily captured between the electrodes when bonding, and thus the electrical continuity between the electrodes can be reliably ensured. In recent years, as the electronic devices have become smaller and thinner, a pitch between terminals in a chip has increasingly become narrower and an electrode pad has become more micro-sized. Thus, in the light of ease of capturing the conductive particles, the ACF has become more commonly employed as the adhesive agent.

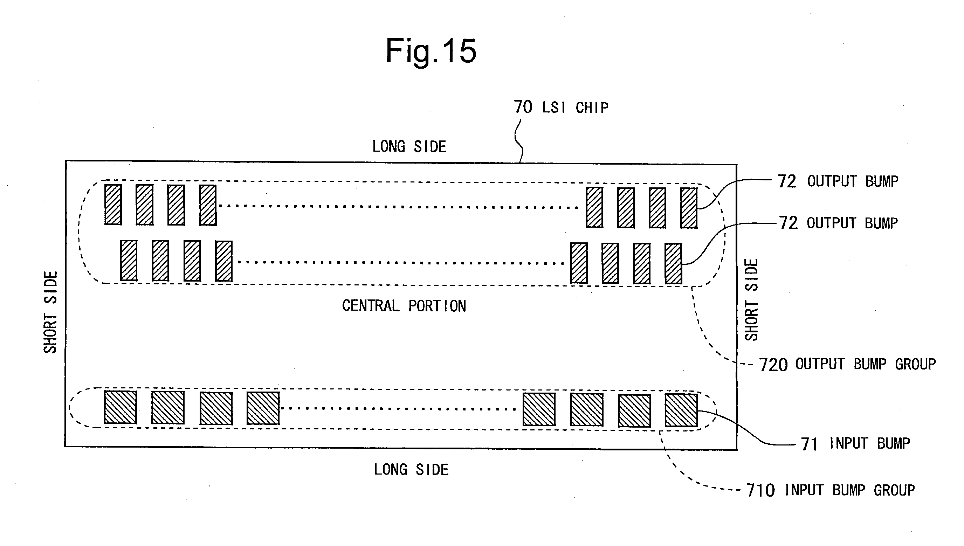

Fig. 15 is a bottom plan view of a conventional LSI chip 70 that is used as a drive circuit of a liquid crystal display device. On a bottom surface of the LSI chip 70, an input bump group 710 including a plurality of input bumps (input terminals) 71 aligned in a line along one long side, and an output bump group 720 including a plurality of output bumps (output terminals) 72 arranged in a staggered manner along the other long side are provided. The input bump group 710 and the output bump group 720 are connected by an ACF to electrode pads provided on a circuit board on which the LSI chip 70 is mounted. To the electrode pads connected with the input bump group 710, electrical signals for causing the LSI chip 70 to operate are supplied. To the electrode pads connected with the output bump group 720, scanning signal lines and video signal lines are connected, to which driving signals are supplied from the LSI chip 70 through the corresponding electrode pads.

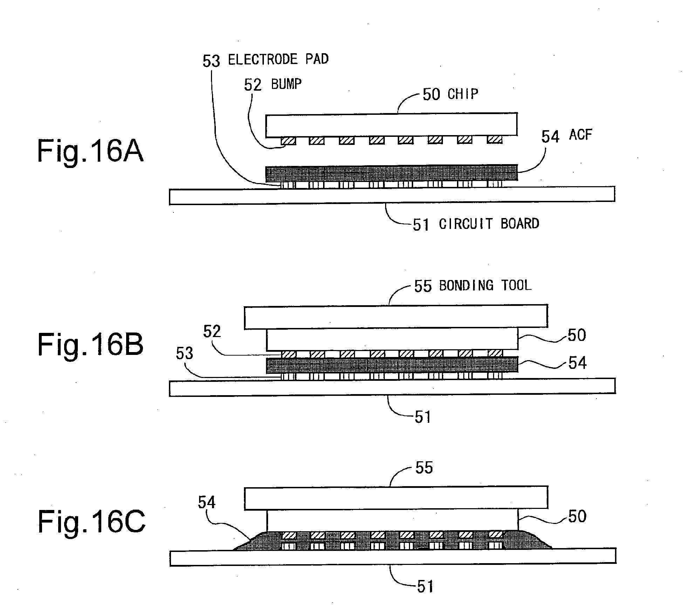

Next, how a chip (for example, the LSI chip 70 shown in Fig. 15) is mounted on a circuit board using an ACF is described. First, as shown in Fig. 16A, a circuit board 51 on which electrode pads 53 for electrical connection with a chip 50 are formed and the chip 50 on which bumps 52 are formed are prepared, and an ACF 54 is applied to the circuit board 51 so as to cover the electrode pads 53. Then, as shown in Fig. 16B, thermocompression bonding of the chip 50 to the circuit board 51 is carried out by a bonding tool 55. The thermocompression bonding is carried out in a state in which positions of the bumps 52 provided on a bottom surface of the chip 50 and positions of the electrode pads 53 on the circuit board 51 are aligned. By the thermocompression bonding, a resin composing the ACF 54 (hereinafter referred to as an "ACF resin") melts, and the ACF resin flows outwardly from a central portion of the chip 50 as shown in Fig. 16C. At this time, as the ACF resin is filled between the bumps 52, electrical continuity between the bumps 52 on the bottom surface of the chip 50 and the electrode pads 53 on the circuit board 51 is ensured by the conductive particles contained in the ACF resin.

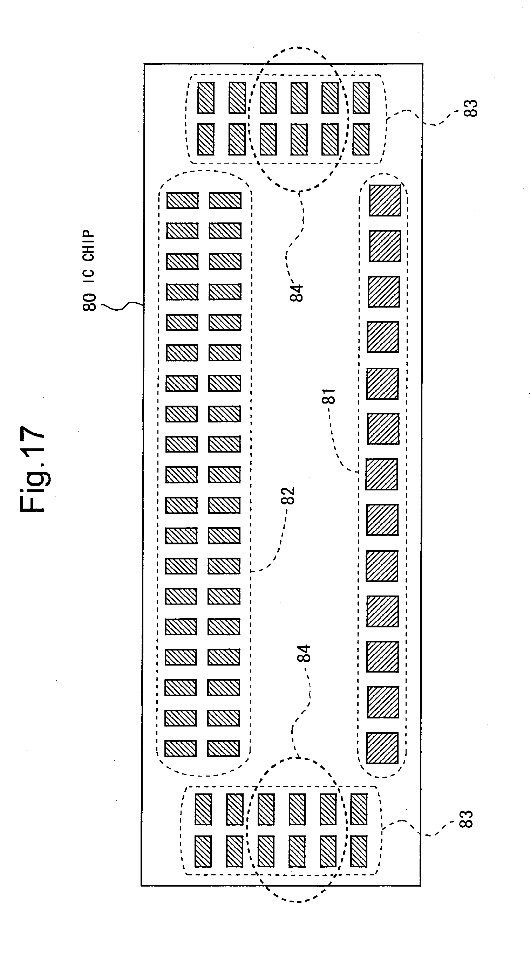

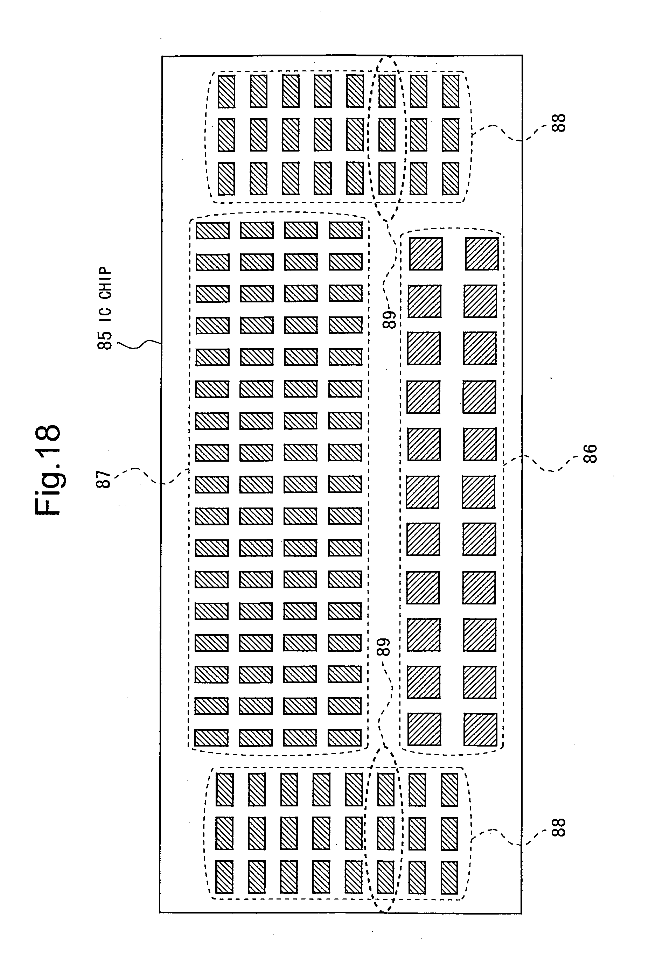

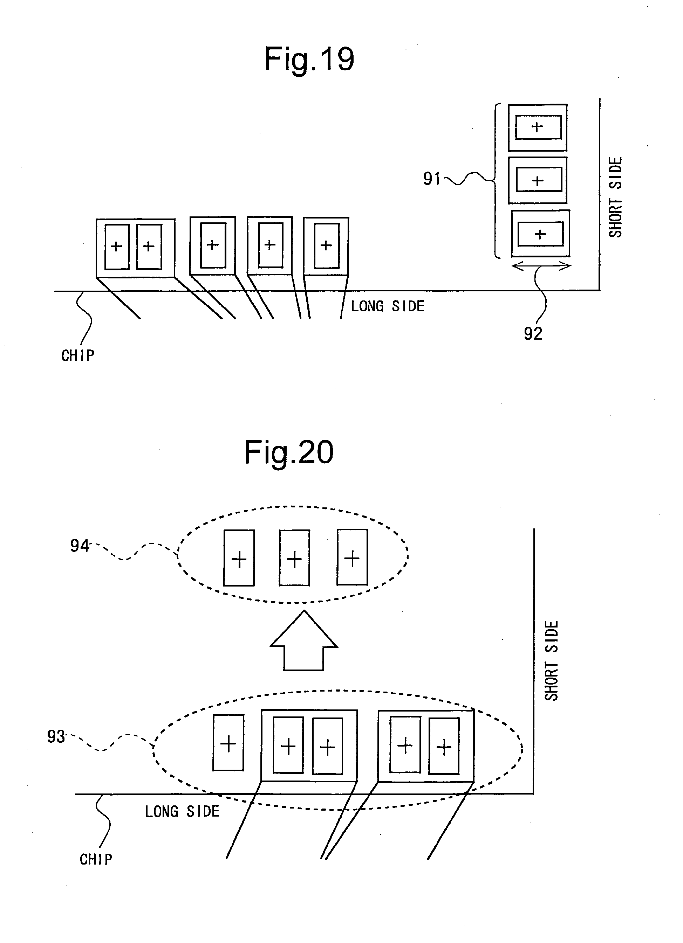

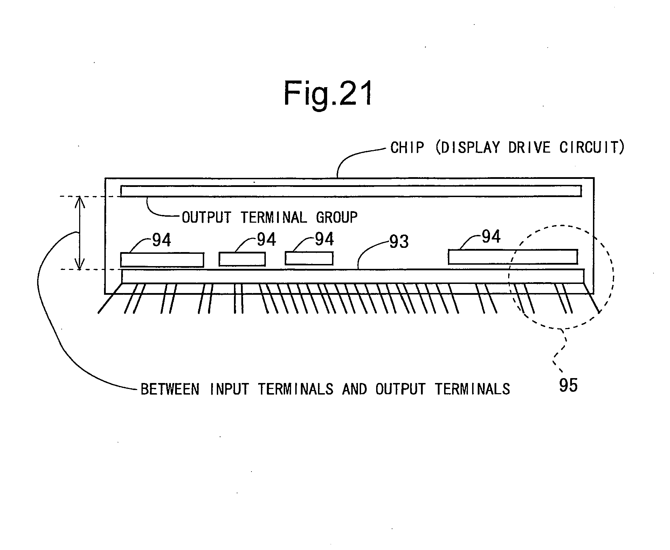

It should be noted that the following conventional techniques are known in the art relating to the invention of the present application. Japanese Unexamined Patent Application Publication No. 2004-252466 discloses an invention of IC chips 80 and 85 having a bottom surface of a configuration illustrated in Figs. 17 and 18. In Fig. 17, an input bump group, an output bump group connected to video signal lines, and an output bump group connected to scanning signal lines are respectively represented by reference numerals 81, 82, and 83. In Fig. 18, an input bump group, an output bump group connected to video signal lines, and an output bump group connected to scanning signal lines are respectively represented by reference numerals 86, 87, and 88. According to the IC chips 80 and 85, it is asserted that flowability of the ACF resin between the output bumps is increased as the output bumps are not arranged in a staggered manner. Further, Japanese Unexamined Patent Application Publication No. 2006-106132 discloses a structure having a terminal group for testing 91 along a short side of a chip as shown in Fig. 19, and a structure having a terminal group for testing 94 inwardly from an input terminal group 93 as shown in Fig. 20. Here, Fig. 20 is a partially enlarged view of a region represented by a reference numeral 95 in Fig. 21. Moreover, Japanese Unexamined Patent Application Publication No. 2007-173738 discloses a technique of providing a dummy wiring conductor portion and thereby preventing intrusion of air bubbles produced within an encapsulating resin to wiring conductors.

### PRIOR ART DOCUMENTS

### PATENT DOCUMENTS

[Patent Document 1] Japanese Unexamined Patent Application Publication No. 2004-252466
[Patent Document 2] Japanese Unexamined Patent Application Publication No. 2006-106132
[Patent Document 3] Japanese Unexamined Patent Application Publication No. 2007-173738

### SUMMARY OF THE INVENTION

### PROBLEMS TO BE SOLVED BY THE INVENTION

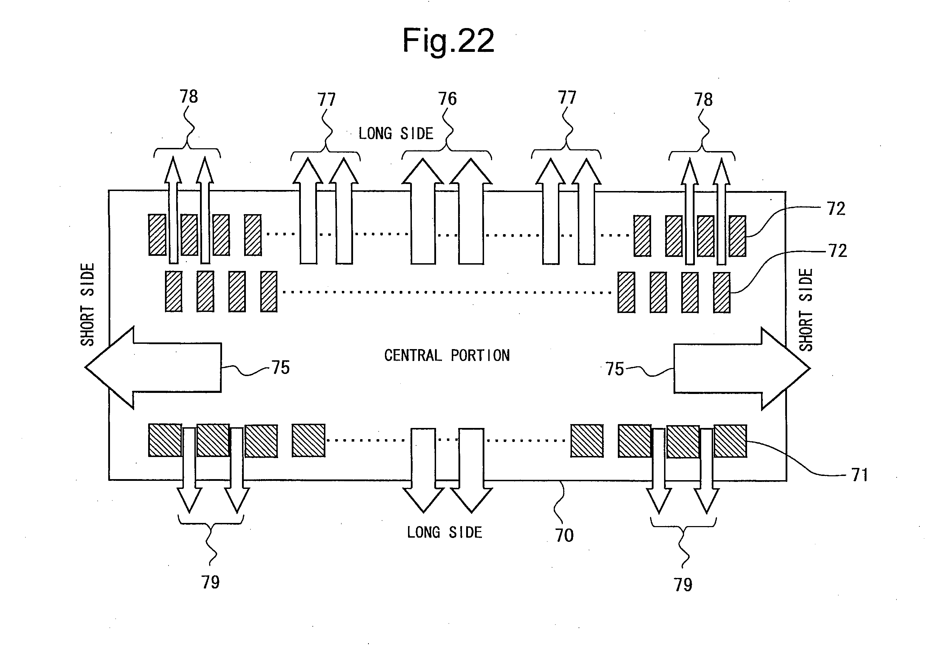

Due to the fact that the pitch between terminals has become narrower as described above, there is often a case in which electrical connection between the output bumps of the chip and the electrode pads of the circuit board becomes poor (hereinafter referred to as "poor connection") at four corners of the bottom surface of the chip (hereinafter referred to as "corner portions"). This will be explained in the below. Fig. 22 is a view for explanation of flows of an ACF resin on the bottom surface of the LSI chip 70, where a pitch between the terminals of the LSI chip 70 shown in Fig. 15 is narrowed. In Fig. 22, directions indicated by arrows represent the flows of the ACF resin, and a width of each arrow represents a magnitude of the flow (flow amount) of the ACF resin. The amount of the flows toward the short sides from the central portion is considerably large as indicated by the arrows represented by a reference numeral 75, as there is no bump in a region between the input bumps 71 and the output bumps 72. Out of the flows toward the long sides from the central portion, the amount of the flow toward the side of the output bumps 72 decreases from a center of the long side to the corner portions as indicated by the arrows represented by reference numerals 76 to 78. This is because the ACF resin cannot easily flow through the output bumps 72 as the output bumps 72 are arranged in a staggered manner at a narrow pitch. Further, as for the ACF resin, since the flow amount in the direction to which the ACF resin can easily flow becomes large, the amount of the flows toward the long sides from the central portion decreases by the increased amount of the flows toward the short sides from the central portion as described above. In this manner, the flow amount becomes considerably small especially near the corner portions of the LSI chip 70, as indicated by the arrows represented by the reference numeral 78. As a result, the poor connection as described above can occur near the corner portions. It should be noted that, as for the flows toward the input bumps 71 out of the flows toward the long sides from the central portion, as the input bumps 71 are provided at a pitch not narrower than that of the output bumps 72, the flow amount that does not cause the poor connection is ensured even near the corner portions as indicated by the arrows represented by a reference numeral 79.

Thus, an object of the present invention is to realize a semiconductor chip having a narrowed pitch between terminals, the chip being capable of suppressing occurrence of poor connection between the chip and a substrate on which the chip is mounted.

### MEANS FOR SOLVING THE PROBLEMS

A first aspect of the present invention is directed to a semiconductor chip having a rectangular bottom surface, and including a first bump electrode group and a second bump electrode group, the first bump electrode group including a plurality of bump electrodes configured for receiving inputted signals from external source and aligned along one long side of the bottom surface, the second bump electrode group including a plurality of bump electrodes configured for outputting outputted signals to external and aligned along the other long side of the bottom surface, the semiconductor chip comprising:
a third bump electrode group provided in an area between an area where the first bump electrode group is formed and an area where the second bump electrode group is formed in the bottom surface, the third bump electrode group including a plurality of rectangular bump electrodes which have long side extending along a direction perpendicular to the long sides of the bottom surface, wherein
the plurality of bump electrodes included in the third bump electrode group are electrodes without external electrical connection.

According to a second aspect of the present invention, in the first aspect of the present invention,
the plurality of bump electrodes included in the third bump electrode group comprise bump electrodes provided only near one short side and the other short side of the bottom surface.

According to a third aspect of the present invention, in the first aspect of the present invention,
the long side of the plurality of bump electrodes included in the third bump electrode group is equal to or longer than one-half of a distance between the area where the first bump electrode group is formed and the area where the second bump electrode group is formed.

According to a fourth aspect of the present invention, in the first aspect of the present invention,
the third bump electrode group is configured by a plurality of bump electrode lines, the plurality of bump electrode lines including at least a bump electrode line including a plurality of bump electrodes aligned in a line along the area where the first bump electrode group is formed and a bump electrode line including a plurality of bump electrodes aligned in a line along the area where the second bump electrode group is formed.

According to a fifth aspect of the present invention, in the first aspect of the present invention,
the plurality of bump electrodes included in the third bump electrode group are formed such that the bump electrodes relatively displaced toward one long side of the bottom surface and the bump electrodes relatively displaced toward the other long side of the bottom surface are arranged alternately.

According to a sixth aspect of the present invention, in the first aspect of the present invention,
the plurality of bump electrodes included in the third bump electrode group are formed such that their long sides become longer as positions of them become closer to the short sides from the central portion of the bottom surface.

According to a seventh aspect of the present invention, in the first aspect of the present invention,
the third bump electrode group comprises a bump electrode line including a plurality of bump electrodes aligned in a line along the area where the first bump electrode group is formed and a bump electrode line including a plurality of bump electrodes aligned in a line along the area where the second bump electrode group is formed, and
the plurality of bump electrodes included in each bump electrode line are formed such that their long sides become longer as positions of them become closer to the short sides from the central portion of the bottom surface.

According to an eighth aspect of the present invention, in the first aspect of the present invention,
the second bump electrode group is configured by a plurality of bump electrode lines, the plurality of bump electrode lines including at least a bump electrode line including a plurality of bump electrodes aligned in a line along one long side of the bottom surface and a bump electrode line including a plurality of bump electrodes aligned in a line along the area where the third bump electrode group is formed.

A ninth aspect of the present invention is directed to a liquid crystal module including a liquid crystal panel which comprises a first substrate and a second substrate that face each other, the first substrate being provided with a drive circuit for driving the liquid crystal panel, wherein
a semiconductor chip according to any one of the first through the eighth aspects of the present invention is mounted as the drive circuit on the first substrate using an anisotropic conductive film.

A tenth aspect of the present invention is directed to a mounting structure in which a semiconductor chip having a rectangular bottom surface is mounted on a circuit board, on which an electrical wiring is formed, using an anisotropic conductive film, wherein
the semiconductor chip includes:
a first bump electrode group including a plurality of bump electrodes configured for receiving inputted signals from the electrical wiring on the circuit board and aligned along one long side of the bottom surface;
a second bump electrode group including a plurality of bump electrodes configured for outputting outputted signals to the electrical wiring on the circuit board and aligned along the other long side of the bottom surface; and
a third bump electrode group provided in an area between an area where the first bump electrode group is formed and an area where the second bump electrode group is formed, the third bump electrode group including a plurality of rectangular bump electrodes which have long side extending along a direction perpendicular to the long sides of the bottom surface, and
the plurality of bump electrodes included in the third bump electrode group are electrodes without electrical connection with the electrical wiring on the circuit board.

According to an eleventh aspect of the present invention, in the tenth aspect of the present invention,
the plurality of bump electrodes included in the third bump electrode group comprise bump electrodes provided only near one short side and the other short side of the bottom surface.

According to a twelfth aspect of the present invention, in the tenth aspect of the present invention,
the long side of the plurality of bump electrodes included in the third bump electrode group is equal to or longer than one-half of a distance between the area where the first bump electrode group is formed and the area where the second bump electrode group is formed.

According to a thirteenth aspect of the present invention, in the tenth aspect of the present invention,
the third bump electrode group is configured by a plurality of bump electrode lines, the plurality of bump electrode lines including at least a bump electrode line including a plurality of bump electrodes aligned in a line along the area where the first bump electrode group is formed and a bump electrode line including a plurality of bump electrodes aligned in a line along the area where the second bump electrode group is formed.

According to a fourteenth aspect of the present invention, in the tenth aspect of the present invention,
the plurality of bump electrodes included in the third bump electrode group are formed such that the bump electrodes relatively displaced toward one long side of the bottom surface and the bump electrodes relatively displaced toward the other long side of the bottom surface are arranged alternately.

According to a fifteenth aspect of the present invention, in the tenth aspect of the present invention,
the plurality of bump electrodes included in the third bump electrode group are formed such that their long sides become longer as positions of them become closer to the short sides from the central portion of the bottom surface.

According to a sixteenth aspect of the present invention, in the tenth aspect of the present invention,
the third bump electrode group comprises a bump electrode line including a plurality of bump electrodes aligned in a line along the area where the first bump electrode group is formed and a bump electrode line including a plurality of bump electrodes aligned in a line along the area where the second bump electrode group is formed, and
the plurality of bump electrodes included in each bump electrode line are formed such that their long sides become longer as positions of them become closer to the short sides from the central portion of the bottom surface.

According to a seventeenth aspect of the present invention, in the tenth aspect of the present invention,
the second bump electrode group is configured by a plurality of bump electrode lines, the plurality of bump electrode lines including at least a bump electrode line including a plurality of bump electrodes aligned in a line along one long side of the bottom surface and a bump electrode line including a plurality of bump electrodes aligned in a line along the area where the third bump electrode group is formed.

According to an eighteenth aspect of the present invention, in any one of the tenth through the seventeenth aspects of the present invention,
the circuit board is one of two substrates that constitute a liquid crystal panel included in a liquid crystal module, and
the semiconductor chip is a drive circuit for driving the liquid crystal panel.

### EFFECTS OF THE INVENTION

According to the first aspect of the present invention, on the bottom surface of the semiconductor chip, the third bump electrode group, which includes the plurality of bump electrodes which have long side extending along the direction perpendicular to the long sides of the bottom surface of the semiconductor chip, is provided in the area between the first bump electrode group for receiving inputted signals and the second bump electrode group for outputting outputted signals. Therefore, when the semiconductor chip is mounted on the circuit board using an anisotropic conductive film, a flow of a resin (conductive resin) that constitutes the anisotropic conductive film is blocked by the third bump electrode group. Accordingly, as compared to the conventional configuration, a greater amount of conductive resin flows toward the long sides from the central portion of the semiconductor chip. As a result, the sufficient flow of the conductive resin is ensured even near the corner portions of the semiconductor chip, thereby suppressing occurrence of poor connection due to insufficiency in the flow amount of the conductive resin.

Further, the plurality of bump electrodes included in the third bump electrode group are not provided with a function of electrical connection. Therefore, as no electrical signal is transmitted through the plurality of bump electrodes included in the third bump electrode group, it is possible to arrange the plurality of bump electrodes for blocking the flow of the conductive resin on the bottom surface of the semiconductor chip without considering a wiring pattern and such. Accordingly, it is possible to make a pitch between the terminals of the semiconductor chip narrower without increasing the chip size.

According to the second aspect of the present invention, the bump electrodes for blocking the flow of the conductive resin are provided only near the both short sides of the bottom surface of the semiconductor chip. Therefore, it is possible to allow a greater amount of conductive resin than that in the conventional example to flow near the corner portions of the semiconductor chip without decreasing a degree of flexibility in designing the semiconductor chip. Accordingly, it is possible to suppress occurrence of poor connection near the corner portion where the flow amount of the conductive resin is most susceptible to insufficiency, while effectively preventing the chip size from increasing.

According to the third aspect of the present invention, in the bottom surface of the semiconductor chip, most of the flow of the conductive resin toward the short sides from the central portion is blocked by the third bump electrodes. Therefore, the occurrence of poor connection due to insufficiency in the flow amount of the conductive resin near the corner portions of the semiconductor chip is reliably suppressed.

According to the fourth aspect of the present invention, in the semiconductor chip in which the length of the bump electrodes is limited, the flow of the conductive resin toward the short sides from the central portion of the bottom surface of the semiconductor chip can be blocked relatively effectively. Therefore, the sufficient flow of the conductive resin is ensured even near the corner portions of the semiconductor chip. Accordingly, the occurrence of poor connection due to insufficiency in the flow amount of the conductive resin is suppressed in the semiconductor chip in which the length of the bump electrodes is limited.

According to the fifth aspect of the present invention, similarly to the fourth aspect of the present invention, the occurrence of poor connection due to insufficiency in the flow amount of the conductive resin is suppressed in the semiconductor chip in which the length of the bump electrodes is limited.

According to the sixth aspect of the present invention, on the bottom surface of the semiconductor chip, the flow of the conductive resin can be blocked effectively as becoming closer to the short sides from the central portion. By contrast, on the bottom surface of the semiconductor chip, an occupied area of the third bump electrodes decreases as becoming closer to the central portion from the short sides. Thus, the occurrence of poor connection due to insufficiency in the flow amount of the conductive resin is suppressed while ensuring a certain degree of flexibility in designing the semiconductor chip.

According to the seventh aspect of the present invention, similarly to the sixth aspect of the present invention, the occurrence of poor connection due to insufficiency in the flow amount of the conductive resin is suppressed while ensuring a certain degree of flexibility in designing the semiconductor chip.

According to the eighth aspect of the present invention, it is possible to achieve the same effect as the first aspect of the present invention in the semiconductor chip in which the second bump electrode group for outputting outputted signals externally is configured with the plurality of bump electrode lines.

According to the ninth aspect of the present invention, it is possible to achieve the liquid crystal module in which the semiconductor chip providing the same effect as any one of the first to eighth aspects of the present invention is mounted on the substrate of the liquid crystal panel.

### BRIEF DESCRIPTION OF THE DRAWINGS

Fig. 1 is a bottom plan view of an LSI chip in a first embodiment according to the present invention.
Fig. 2 is a plan view of a liquid crystal module provided with the LSI chip of the first embodiment.
Fig. 3 is a cross-sectional view taken along line A-A in Fig. 1.
Figs. 4A and 4B are illustrative diagrams for explanation of an effect of the first embodiment.
Fig. 5 is an illustrative diagram for explanation of flows of an ACF resin in the first embodiment.
Figs. 6A and 6B are illustrative diagrams for explanation of an effect of the first embodiment.
Fig. 7 is a bottom plan view of an LSI chip in a second embodiment according to the present invention.
Fig. 8 is a bottom plan view of an LSI chip in a third embodiment according to the present invention.
Fig. 9 is a bottom plan view of an LSI chip of a modified example of the third embodiment.
Fig. 10 is a bottom plan view of an LSI chip of a modified example of the third embodiment.
Fig. 11 is a bottom plan view of an LSI chip of a modified example of the third embodiment.
Fig. 12 is a bottom plan view of an LSI chip of a modified example of the third embodiment.
Fig. 13 is a bottom plan view of an LSI chip in a fourth embodiment according to the present invention.
Fig. 14 is a bottom plan view of an LSI chip of a modified example of the fourth embodiment.
Fig. 15 is a bottom plan view of a conventional LSI chip that is used as a drive circuit of a liquid crystal display device.
Figs. 16A to 16C are illustrative diagrams for explanation of how the chip is mounted on a circuit board using an ACF.
Fig. 17 is a bottom plan view of a conventional IC chip.
Fig. 18 is a bottom plan view of a conventional IC chip.
Fig. 19 is a bottom plan view of a conventional chip.
Fig. 20 is a partially enlarged view of a bottom plan view of a conventional chip.
Fig. 21 is the bottom plan view of the conventional chip.
Fig. 22 is an illustrative diagram for explanation of flows of an ACF resin in a conventional example.

### MODE FOR CARRYING OUT THE INVENTION

Embodiments of the present invention will now be described with reference to the accompanying drawings.

### <1. First Embodiment>

### <1.1 Configuration of Liquid Crystal Module>

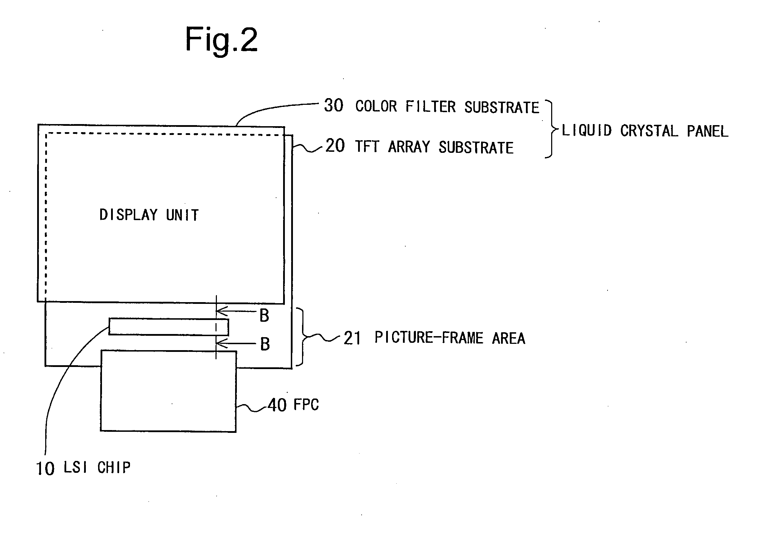

Fig. 2 is a plan view of a liquid crystal module provided with an LSI chip (semiconductor chip) according to a first embodiment of the present invention. The liquid crystal module is provided with a liquid crystal panel, an LSI chip 10, and an FPC (Flexible Printed Circuit) 40. The liquid crystal panel is provided with a TFT array substrate 20, on which a TFT array is formed, which includes pixel electrodes (display electrodes), and a color filter substrate 30 on which a color filter for color display as well as opposite electrodes for applying a voltage between the opposite electrodes and the pixel electrodes with a liquid crystal layer interposed therebetween are formed. Both the TFT array substrate 20 and the color filter substrate 30 are a glass substrate. Further, as shown in Fig. 2, the TFT array substrate 20 is larger than the color filter substrate 30 in a planar view. A display unit is provided in an area where the TFT array substrate 20 and the color filter substrate 30 overlap in a planar view. An area of the TFT array substrate 20 that does not face toward the color filter substrate 30 is generally referred to as a "picture-frame". In this embodiment, the LSI chip 10 for driving the liquid crystal panel is mounted in an area that corresponds to the picture-frame (hereinafter referred to as a "picture-frame area") 21, the FPC 40 including such as a controller for controlling operation of the LSI chip 10 is connected to this area, and thus the liquid crystal module is achieved. As described above, a configuration in which the LSI chip 10 is mounted on the glass substrate, i.e., a COG (Chip On Glass) method, is employed in this embodiment. Note that, in Fig. 2, the color filter substrate 30 is shown slightly displaced to upper left in a planar view for convenience of illustration.

### <1.2 Configuration of Bottom Surface of LSI Chip>

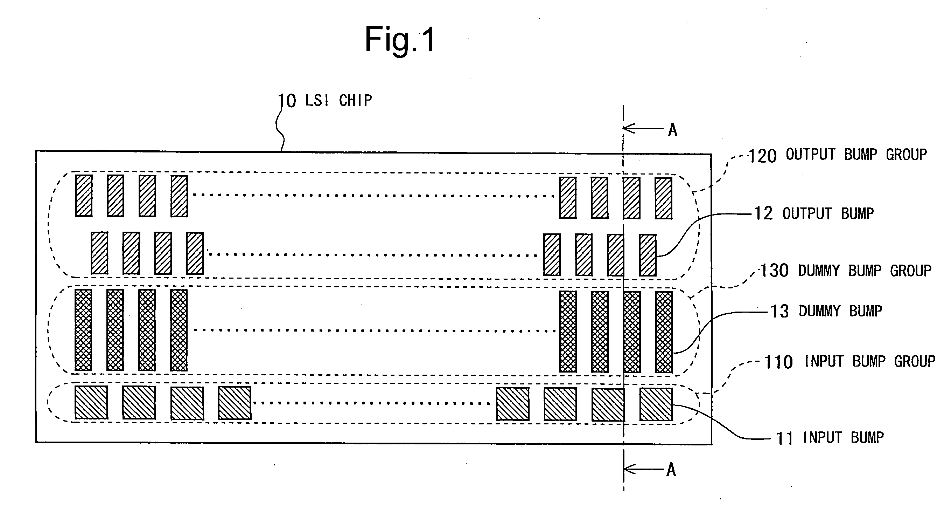

Fig. 1 is a bottom plan view of the LSI chip 10 in this embodiment. As shown in Fig. 1, on a bottom surface of the LSI chip 10, an input bump group 110 including a plurality of input bumps 11 aligned in a line along one long side, an output bump group 120 including a plurality of output bumps 12 arranged in a staggered manner along the other long side, and a dummy bump group 130 including a plurality of dummy bumps 13 aligned in a line in an area between an area on which the input bump group 110 is provided and an area on which the output bump group 120 is provided, are provided. Here, the dummy bumps 13 are bumps without a function of electrical connection. The input bump group 110 is connected by an ACF to electrode pads provided on the TFT array substrate 20 on which the LSI chip 10 is mounted. Further, electrical signals for causing the LSI chip 10 to operate are supplied to the electrode pads connected with the input bump group 110. The output bump group 120 is also connected by an ACF to electrode pads provided on the TFT array substrate 20 on which the LSI chip 10 is mounted. Moreover, to the electrode pads connected with the output bump group 120, scanning signal lines and video signal lines are connected, to which driving signals are supplied from the LSI chip 10 through the corresponding electrode pads.

It should be noted that, in this embodiment, a first bump electrode group is realized by the input bump group 110, a second bump electrode group is realized by the output bump group 120, and a third bump electrode group is realized by the dummy bump group 130.

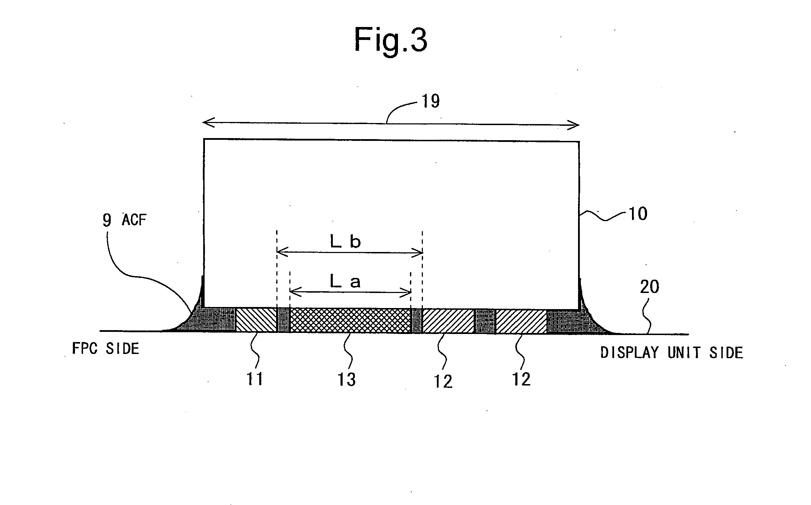

Fig. 3 is a cross-sectional view taken along line A-A in Fig. 1 (cross-sectional view taken along line B-B in Fig. 2). As shown in Fig. 3, the dummy bumps 13 are provided between the input bumps 11 provided near one end of the bottom surface of the LSI chip 10 (FPC side) and the output bumps 12 provided near the other end of the bottom surface of the LSI chip 10 (display unit side). The TFT array substrate 20 and the LSI chip 10 are bonded to each other by an ACF 9. Here, focusing attention on a length of each bump in an across-the-width direction (direction indicated by an arrow represented by a reference numeral 19) on the bottom surface of the LSI chip 10, the dummy bumps 13 are typically configured to be longer than the input bumps 11 and the output bumps 12. Further, in order to block flows of an ACF resin as will be described later, a length La of the long side of the dummy bumps 13 is set to be as close to a length Lb between the input bumps 11 and the output bumps 12 as possible. For example, it is preferable that the La be equal to or longer than one-half of the Lb. Further, it is more preferable that the La be equal to or longer than three-fifths of the Lb. It should be noted that, in Fig. 3, the electrode pads on the TFT array substrate 20 are not shown.

### <1.3 Effects>

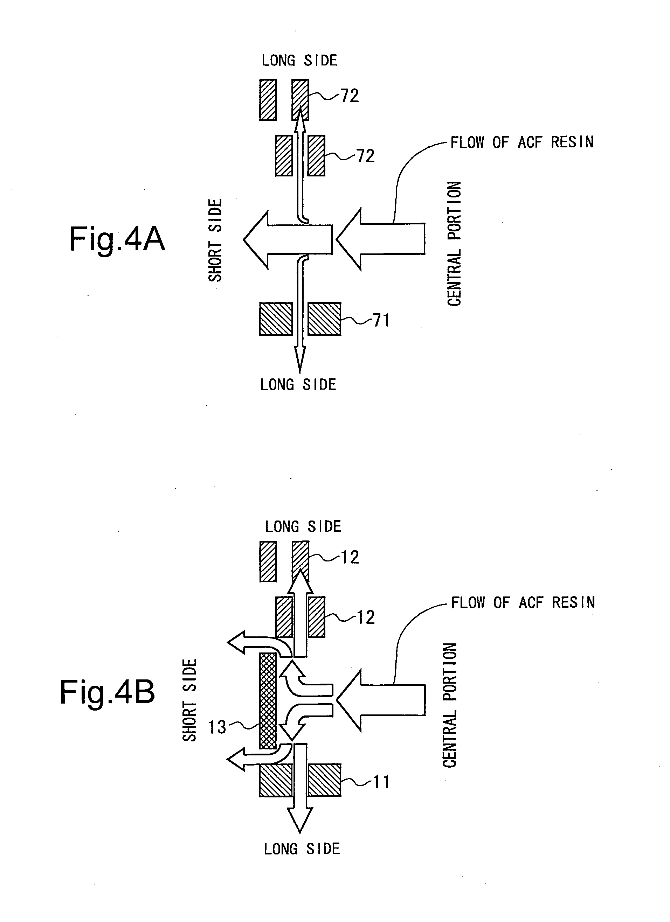

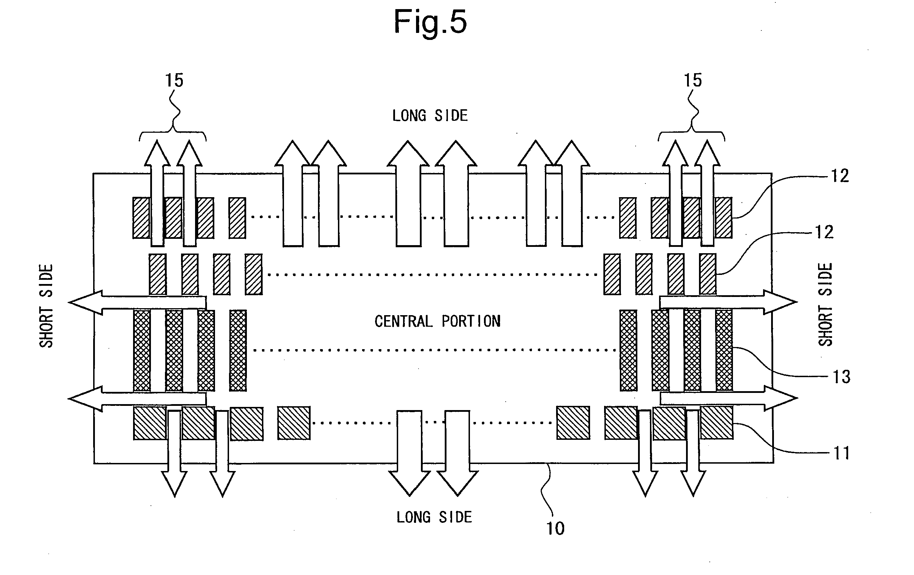

According to the conventional configuration shown in Fig. 15, any bumps or the like that block the flows of the ACF resin are not provided in an area between the input bump group 710 aligned in a line along one long side of the bottom surface of the LSI chip 70 and the output bump group 720 arranged in a staggered manner along the other long side of it. Accordingly, as shown in Fig. 4A, the flow amount of the ACF resin toward the long sides from the central portion is considerably smaller than that toward the short sides from the central portion. This consequently makes the flow amount of the ACF resin noticeably insufficient near the corner portions of the LSI chip 70 (see Fig. 22), and fails to achieve sufficiently reliable connection due to insufficiency in response and the amount of the resin, resulting in poor connection. By contrast, according to the configuration of this embodiment, the dummy bump group 130 including the plurality of the dummy bumps 13 which have long side in the direction perpendicular to a large flow of the ACF resin is provided in the area between the input bump group 110 and the output bump group 120, as shown in Fig. 1. Accordingly, as shown in Fig. 4B, the flows of the ACF resin toward the short sides from the central portion are blocked by the dummy bumps 13, and a greater amount of the ACF resin flows toward the long sides from the central portion as compared to the conventional configuration. With this, the sufficient flow of the ACF resin is ensured even near the corner portions of the LSI chip 10 as indicated by an arrow represented by a reference numeral 15 in Fig. 5, thereby suppressing occurrence of poor connection due to insufficiency in the flow amount of the ACF resin.

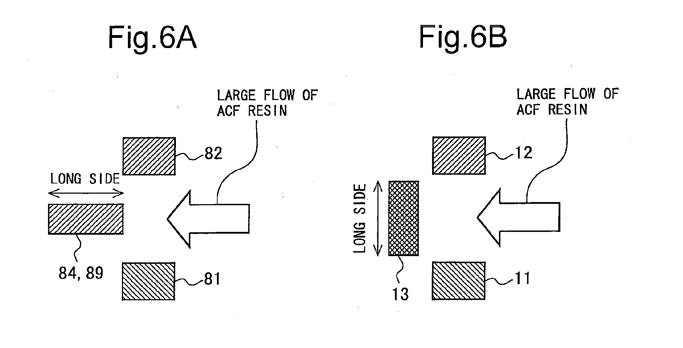

Further, according to the conventional configuration shown in Fig. 17, the bumps represented by a reference numeral 84 can correspond to the dummy bumps 13 in this embodiment. According to the conventional configuration shown in Fig. 18, the bumps represented by a reference numeral 89 can correspond to the dummy bumps 13 in this embodiment. However, while the dummy bumps 84 and 89 according to the conventional configurations have the long sides which extend along the direction of the large flow of the ACF resin as shown in Fig. 6A, the dummy bumps 13 according to this embodiment have the long sides which extend along the direction perpendicular to the large flow of the ACF resin as shown in Fig. 6B. Therefore, according to this embodiment, it is possible to effectively change the direction of the flow of the ACF resin toward the long sides (of the bottom surface of the LSI chip), and whereby a sufficient flow amount of the ACF resin can be reliably ensured even near the corner portions of the LSI chip 10.

As described above, in mounting the LSI chip 10 having a narrowed pitch between terminals (bumps) on the TFT array substrate 20, the occurrence of poor connection due to insufficiency in the flow amount of the ACF resin (poor electrical connection between the output bumps 12 on the bottom surface of the LSI chip 10 and the electrode pads on the TFT array substrate 20) that has conventionally occurred near the corner portions of the LSI chip 10 is suppressed. As a result, it is possible to provide a highly reliable liquid crystal module.

Moreover, in this embodiment, the dummy bumps 13 without a function of electrical connection are employed as a component that blocks the flows of the ACF resin. As no electrical signal is transmitted through the dummy bumps 13, it is possible to arrange the plurality of dummy bumps 13 on the bottom surface of the LSI chip 10 without considering a wiring pattern and such. Therefore, layout efficiency in designing an LSI does not decrease, and it is possible to make the pitch between terminals narrower without increasing the chip size. Thus, a liquid crystal module on which the LSI chip 10 having a narrowed pitch between terminals is mounted is realized.

Furthermore, according to this embodiment, it is possible to employ the LSI chip 10 having a narrowed pitch between terminals for the liquid crystal module without imposing a large burden on conditioning in a connecting step and management work of the connecting step.

### <2. Second Embodiment>

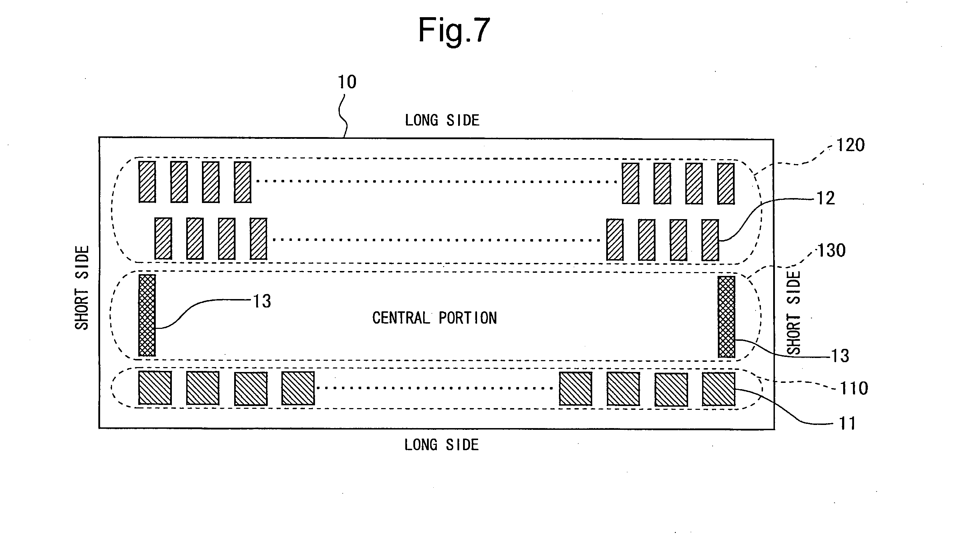

Fig. 7 is a bottom plan view of the LSI chip 10 in a second embodiment according to the present invention. In this embodiment, as shown in Fig. 7, the dummy bumps 13 are provided only near one and the other short sides of the bottom surface of the LSI chip 10. Specifically, only outermost two of the plurality of dummy bumps 13 out of the plurality of the dummy bumps 13 included in the dummy bump group 130 according to the first embodiment (see Fig. 1) are disposed on the bottom surface of the LSI chip 10. Other configurations than this are the same as those in the first embodiment, and therefore an explanation is omitted.

An increased number of the dummy bumps 13 that block the flows of the ACF resin toward the short sides from the central portion provided in the area between the input bump group 110 and the output bump group 120 improves reliability in connection between the LSI chip 10 and the TFT array substrate 20. However, as the number of the dummy bumps 13 provided on the bottom surface of the LSI chip 10 increases, flexibility in designing the LSI chip 10 decreases. Therefore, by employing the configuration in which the dummy bumps 13 are provided only near the both short sides of the bottom surface of the LSI chip 10 as shown in Fig. 7, it is possible to ensure a sufficient flow amount of the ACF resin even near the corner portions of the LSI chip 10 without decreasing flexibility in designing the LSI chip 10. With this, it is possible to suppress occurrence of poor connection near the corner portions where insufficiency in the flow amount of the ACF resin most easily occurs, while effectively preventing the chip size from increasing.

### <3. Third Embodiment>

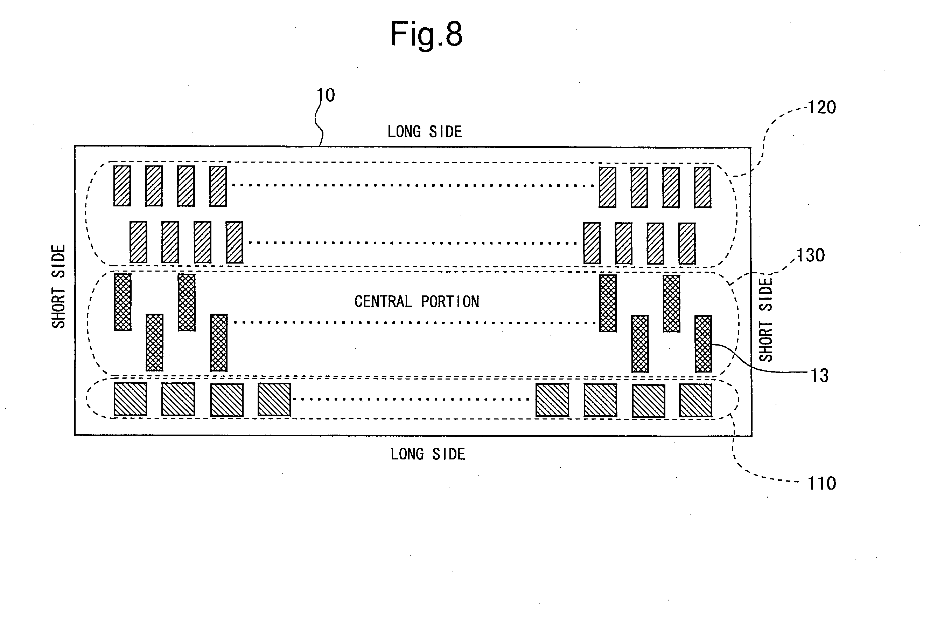

Fig. 8 is a bottom plan view of the LSI chip 10 in a third embodiment according to the present invention. For bump formation on the bottom surface of the LSI chip 10, various limitations can be placed. For example, there is a case in which the length of the long sides of the bumps is limited to be a predetermined length or shorter. In such a case, there is a possibility that a distance between the input bump group 110 and the dummy bump group 130 or a distance between the output bump group 120 and the dummy bump group 130 increases, and that the large flow of the ACF resin toward the short sides from the central portion is not blocked. Therefore, in this embodiment, the dummy bump group 130 is formed such that the dummy bumps 13 relatively displaced toward one long side of the bottom surface of the LSI chip 10 and the dummy bumps 13 relatively displaced toward the other long side of the bottom surface of the LSI chip 10 are arranged alternately, as shown in Fig. 8. Other configurations than this are the same as those in the first embodiment, and therefore an explanation is omitted.

According to this embodiment, the flow of the ACF resin toward the short sides from the central portion can be blocked relatively efficiently in the LSI chip 10 in which the length of the long sides of the bumps is limited to be a predetermined length or shorter. With this, the sufficient flow of the ACF resin is ensured even near the corner portions of the LSI chip 10, thereby suppressing occurrence of poor connection due to insufficiency in the flow amount of the ACF resin.

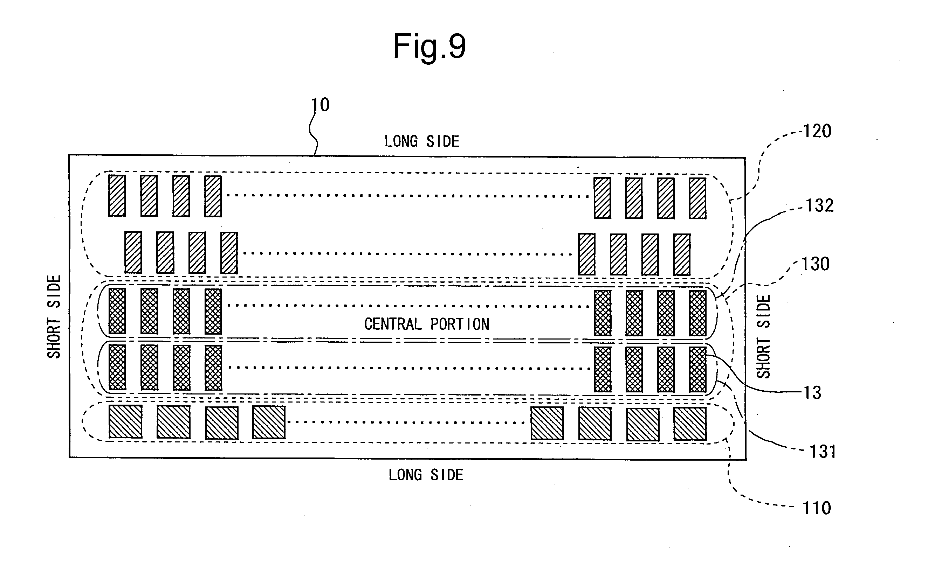

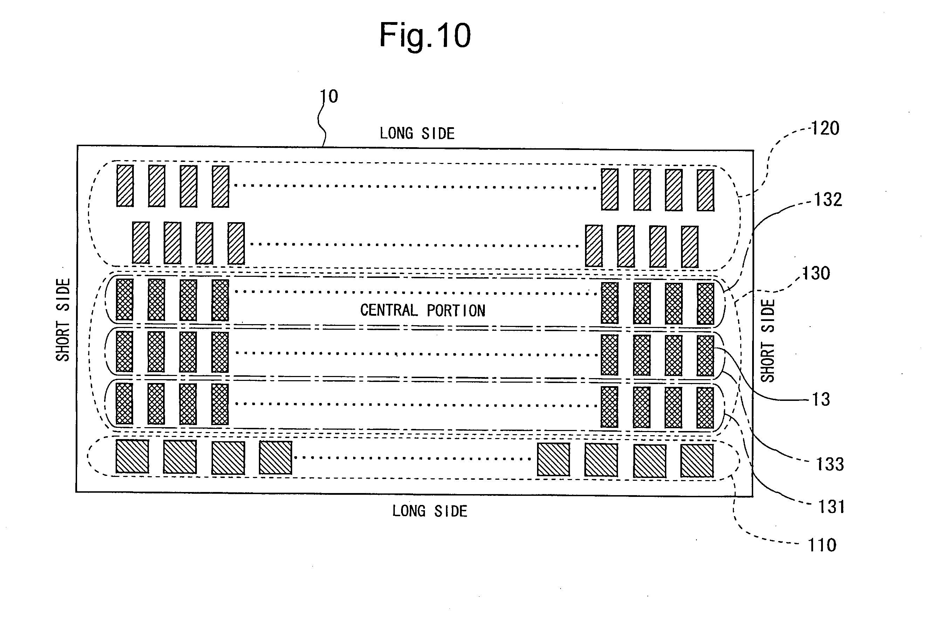

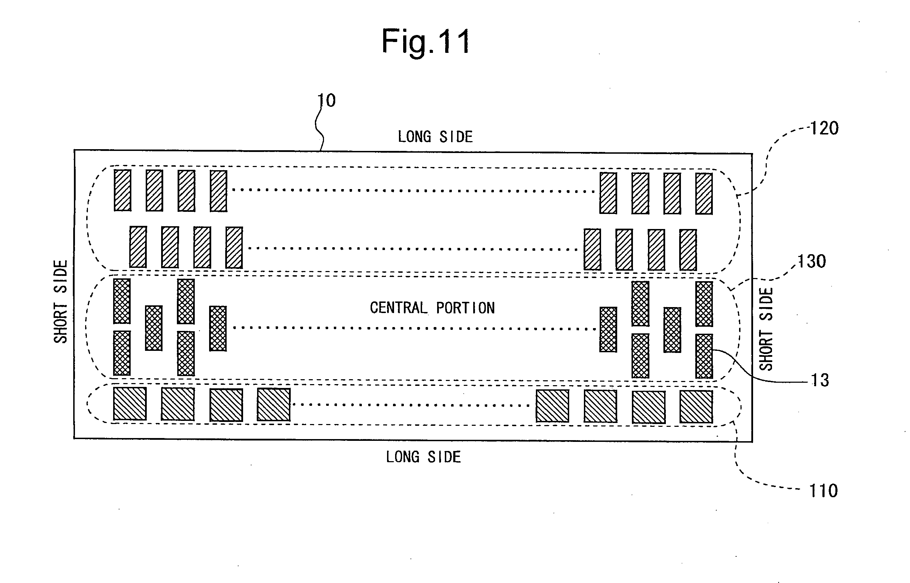

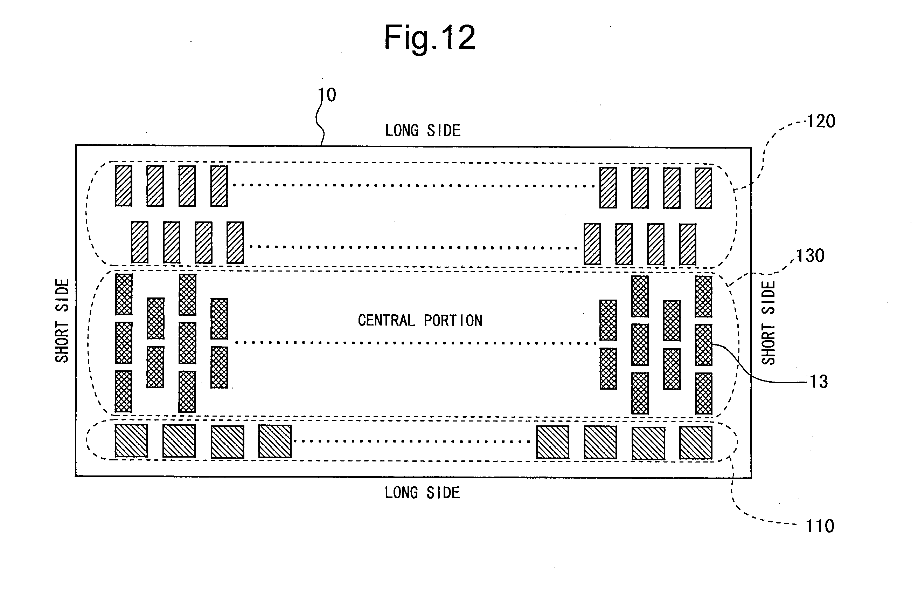

It should be noted that, in the case in which the length of the long sides of the bumps is limited to be a predetermined length or shorter, the dummy bump group 130 can be configured by the plurality of dummy bumps 13 aligned in a plurality of lines, as shown in Figs. 9 and 10, for example. Specifically, in the configuration shown in Fig. 9, the dummy bump group 130 is configured by a dummy bump line 131 including the plurality of dummy bumps 13 aligned in a line along the input bump group 110, and a dummy bump line 132 including the plurality of dummy bumps 13 aligned in a line along the output bump group 120. In the configuration shown in Fig. 10, the dummy bump group 130 is configured by the dummy bump line 131 including the plurality of dummy bumps 13 aligned in a line along the input bump group 110, the dummy bump line 132 including the plurality of dummy bumps 13 aligned in a line along the output bump group 120, and a dummy bump line 133 including the plurality of dummy bumps 13 aligned in a line between the two dummy bump lines 131 and 132. In addition, it is possible to employ a configuration combining the configuration shown in Fig. 8 and the configuration shown in Fig. 9 or Fig. 10, that is, the configuration shown in Fig. 11 or Fig. 12.

### <4. Fourth Embodiment>

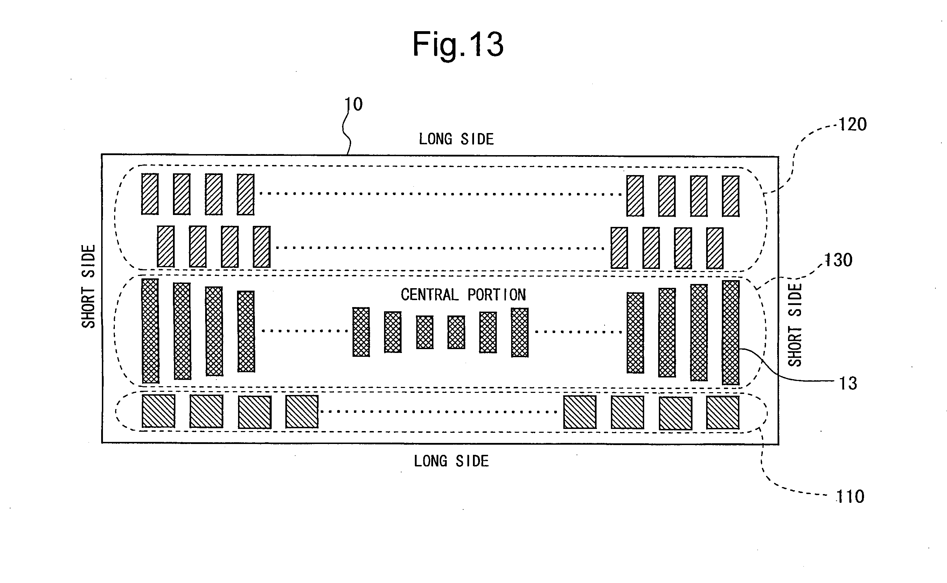

Fig. 13 is a bottom plan view of the LSI chip 10 in a fourth embodiment according to the present invention. As shown in Fig. 22, it is usually possible to ensure a flow amount of the ACF resin near the center of the long sides of the bottom surface sufficient so as not to cause poor connection even in the LSI chip 70 having a narrowed pitch between terminals (see the arrow represented by the reference numeral 76). Therefore, it is considered that the closer it is to the central portion, the less required it is to block the flow of the ACF resin toward the short sides from the central portion. Accordingly, in this embodiment, the plurality of dummy bumps 13 included in the dummy bump group 130 are configured such that their long sides become longer as the positions of the bumps become closer to the short sides from the central portion of the bottom surface of the LSI chip 10, as shown in Fig. 13. Other configurations than this are the same as those in the first embodiment, and therefore an explanation is omitted.

According to the second embodiment, occurrence of poor connection can be suppressed near the corner portion where the flow amount of the ACF resin is most susceptible to insufficiency. In this embodiment, it is possible to suppress occurrence of poor connection not only near the corner portions but also in areas other than the corner portions while ensuring a certain degree of flexibility in designing the LSI chip 10.

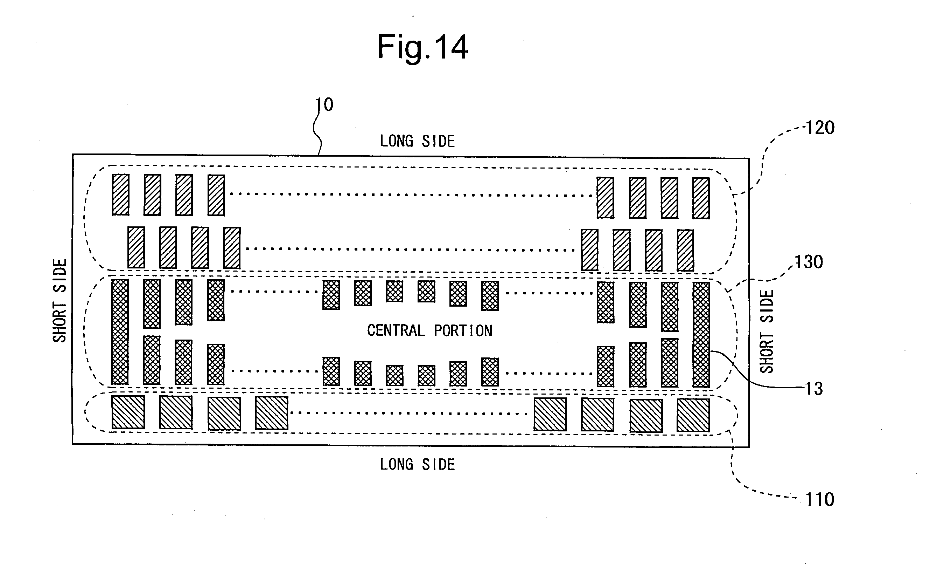

It should be noted that from the same standpoint, it is possible to employ a configuration in which the dummy bump group 130 includes two dummy bump lines, and the plurality of dummy bumps 13 included in each dummy bump line may be formed such that their long sides become longer as the positions of the bumps become closer to the short sides from the central portion of the bottom surface of the LSI chip 10, as shown in Fig. 14.

### <5. Others>

While the above embodiments are described taking the example in which the LSI chip 10 is mounted on the TFT array substrate 20 of a liquid crystal panel, the present invention is not limited to this. The present invention can be applied in order to suppress occurrence of poor connection due to an insufficient flow amount of the ACF resin, as long as a semiconductor chip is mounted on a circuit board using an ACF.

Further, according to the above embodiments, the input bump group 110 is configured by a single line of bumps (the bump line including the plurality of input bumps 12 aligned in a line along one long side of the bottom surface of the LSI chip 10), the output bump group 120 is configured by two lines of bumps (the bump line including the plurality of output bumps 12 aligned in a line along the other long side of the bottom surface of the LSI chip 10 and the bump line including the plurality of output bumps 12 aligned in a line along the area where the dummy bump group 130 is provided). However, the present invention is not limited to this. The present invention can be applied as long as the input bump group 110 and the output bump group 120 are respectively aligned along one long side and the other long side of the LSI chip 10.

### DESCRIPTION OF REFERENCE NUMERALS

- 9:: ACF
- 10:: LSI Chip
- 11:: Input Bump
- 12:: Output Bump
- 13:: Dummy Bump
- 20:: TFT Array Substrate
- 21:: Picture-Frame Area
- 30:: Color Filter Substrate
- 40:: FPC
- 110:: Input Bump Group
- 120:: Output Bump Group
- 130:: Dummy Bump Group

## Claims

1. A semiconductor chip having a rectangular bottom surface, and including a first bump electrode group and a second bump electrode group, the first bump electrode group including a plurality of bump electrodes configured for receiving inputted signals from external source and aligned along one long side of the bottom surface, the second bump electrode group including a plurality of bump electrodes configured for outputting outputted signals to external and aligned along the other long side of the bottom surface, the semiconductor chip comprising:
a third bump electrode group provided in an area between an area where the first bump electrode group is formed and an area where the second bump electrode group is formed in the bottom surface, the third bump electrode group including a plurality of rectangular bump electrodes which have long side extending along a direction perpendicular to the long sides of the bottom surface, wherein
the plurality of bump electrodes included in the third bump electrode group are electrodes without external electrical connection.

2. The semiconductor chip according to claim 1, wherein
the plurality of bump electrodes included in the third bump electrode group comprise bump electrodes provided only near one short side and the other short side of the bottom surface.

3. The semiconductor chip according to claim 1, wherein
the long side of the plurality of bump electrodes included in the third bump electrode group is equal to or longer than one-half of a distance between the area where the first bump electrode group is formed and the area where the second bump electrode group is formed.

4. The semiconductor chip according to claim 1, wherein
the third bump electrode group is configured by a plurality of bump electrode lines, the plurality of bump electrode lines including at least a bump electrode line including a plurality of bump electrodes aligned in a line along the area where the first bump electrode group is formed and a bump electrode line including a plurality of bump electrodes aligned in a line along the area where the second bump electrode group is formed.

5. The semiconductor chip according to claim 1, wherein
the plurality of bump electrodes included in the third bump electrode group are formed such that the bump electrodes relatively displaced toward one long side of the bottom surface and the bump electrodes relatively displaced toward the other long side of the bottom surface are arranged alternately.

6. The semiconductor chip according to claim 1, wherein
the plurality of bump electrodes included in the third bump electrode group are formed such that their long sides become longer as positions of them become closer to the short sides from the central portion of the bottom surface.

7. The semiconductor chip according to claim 1, wherein
the third bump electrode group comprises a bump electrode line including a plurality of bump electrodes aligned in a line along the area where the first bump electrode group is formed and a bump electrode line including a plurality of bump electrodes aligned in a line along the area where the second bump electrode group is formed, and
the plurality of bump electrodes included in each bump electrode line are formed such that their long sides become longer as positions of them become closer to the short sides from the central portion of the bottom surface.

8. The semiconductor chip according to claim 1, wherein
the second bump electrode group is configured by a plurality of bump electrode lines, the plurality of bump electrode lines including at least a bump electrode line including a plurality of bump electrodes aligned in a line along one long side of the bottom surface and a bump electrode line including a plurality of bump electrodes aligned in a line along the area where the third bump electrode group is formed.

9. A liquid crystal module including a liquid crystal panel which comprises a first substrate and a second substrate that face each other, the first substrate being provided with a drive circuit for driving the liquid crystal panel, wherein
a semiconductor chip according to any one of claims 1 to 8 is mounted as the drive circuit on the first substrate using an anisotropic conductive film.

10. A mounting structure in which a semiconductor chip having a rectangular bottom surface is mounted on a circuit board, on which an electrical wiring is formed, using an anisotropic conductive film, wherein
the semiconductor chip includes:
a first bump electrode group including a plurality of bump electrodes configured for receiving inputted signals from the electrical wiring on the circuit board and aligned along one long side of the bottom surface;
a second bump electrode group including a plurality of bump electrodes configured for outputting outputted signals to the electrical wiring on the circuit board and aligned along the other long side of the bottom surface; and
a third bump electrode group provided in an area between an area where the first bump electrode group is formed and an area where the second bump electrode group is formed, the third bump electrode group including a plurality of rectangular bump electrodes which have long side extending along a direction perpendicular to the long sides of the bottom surface, and
the plurality of bump electrodes included in the third bump electrode group are electrodes without electrical connection with the electrical wiring on the circuit board.

11. The mounting structure according to claim 10, wherein
the plurality of bump electrodes included in the third bump electrode group comprise bump electrodes provided only near one short side and the other short side of the bottom surface.

12. The mounting structure according to claim 10, wherein
the long side of the plurality of bump electrodes included in the third bump electrode group is equal to or longer than one-half of a distance between the area where the first bump electrode group is formed and the area where the second bump electrode group is formed.

13. The mounting structure according to claim 10, wherein
the third bump electrode group is configured by a plurality of bump electrode lines, the plurality of bump electrode lines including at least a bump electrode line including a plurality of bump electrodes aligned in a line along the area where the first bump electrode group is formed and a bump electrode line including a plurality of bump electrodes aligned in a line along the area where the second bump electrode group is formed.

14. The mounting structure according to claim 10, wherein
the plurality of bump electrodes included in the third bump electrode group are formed such that the bump electrodes relatively displaced toward one long side of the bottom surface and the bump electrodes relatively displaced toward the other long side of the bottom surface are arranged alternately.

15. The mounting structure according to claim 10, wherein
the plurality of bump electrodes included in the third bump electrode group are formed such that their long sides become longer as positions of them become closer to the short sides from the central portion of the bottom surface.

16. The mounting structure according to claim 10, wherein
the third bump electrode group comprises a bump electrode line including a plurality of bump electrodes aligned in a line along the area where the first bump electrode group is formed and a bump electrode line including a plurality of bump electrodes aligned in a line along the area where the second bump electrode group is formed, and
the plurality of bump electrodes included in each bump electrode line are formed such that their long sides become longer as positions of them become closer to the short sides from the central portion of the bottom surface.

17. The mounting structure according to claim 10, wherein
the second bump electrode group is configured by a plurality of bump electrode lines, the plurality of bump electrode lines including at least a bump electrode line including a plurality of bump electrodes aligned in a line along one long side of the bottom surface and a bump electrode line including a plurality of bump electrodes aligned in a line along the area where the third bump electrode group is formed.

18. The mounting structure according to any one of claims 10 to 17, wherein
the circuit board is one of two substrates that constitute a liquid crystal panel included in a liquid crystal module, and
the semiconductor chip is a drive circuit for driving the liquid crystal panel.
